(19) Europäisches Patentamt
European Patent Office
Office européen des brevets

(11) **EP 2 617 069 B1**

(12) **FASCICULE DE BREVET EUROPEEN**

(45) Date de publication et mention
de la délivrance du brevet:
**03.12.2014 Bulletin 2014/49**

(21) Numéro de dépôt: **11773065.5**

(22) Date de dépôt: **12.09.2011**

(51) Int Cl.:
*H01L 33/06* (2010.01)     *B82Y 20/00* (2011.01)
*H01L 33/08* (2010.01)

(86) Numéro de dépôt international:
**PCT/FR2011/052078**

(87) Numéro de publication internationale:
**WO 2012/035243 (22.03.2012 Gazette 2012/12)**

(54) **DISPOSITIF OPTOÉLECTRONIQUE À BASE DE NANOFILS POUR L'ÉMISSION DE LUMIÈRE**

NANODRAHT-BASIERTE LICHTEMITTIERENDE VORRICHTUNG

NANOWIRE-BASED OPTOELECTRONIC DEVICE FOR LIGHT EMISSION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.05.2011 FR 1154313**
**14.09.2010 FR 1057330**

(43) Date de publication de la demande:
**24.07.2013 Bulletin 2013/30**

(73) Titulaire: **Commissariat à l'Énergie Atomique et aux Énergies Alternatives**
**75015 Paris (FR)**

(72) Inventeurs:
• **GILET, Philippe**
**F-38470 Teche (FR)**

• **BAVENCOVE, Anne-Laure**
**F-38000 Grenoble (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
**WO-A1-2008/079076     WO-A1-2009/106636**
**WO-A2-2008/079077     WO-A2-2008/140611**
**US-A1- 2008 305 568     US-A1- 2009 146 142**
**US-A1- 2010 006 817**

**Description**

**DOMAINE DE L'INVENTION**

L'invention a trait aux dispositifs optoélectroniques à base de nanofils pour la production de lumière, notamment des LED (diodes électroluminescentes).

**ETAT DE LA TECHNIQUE**

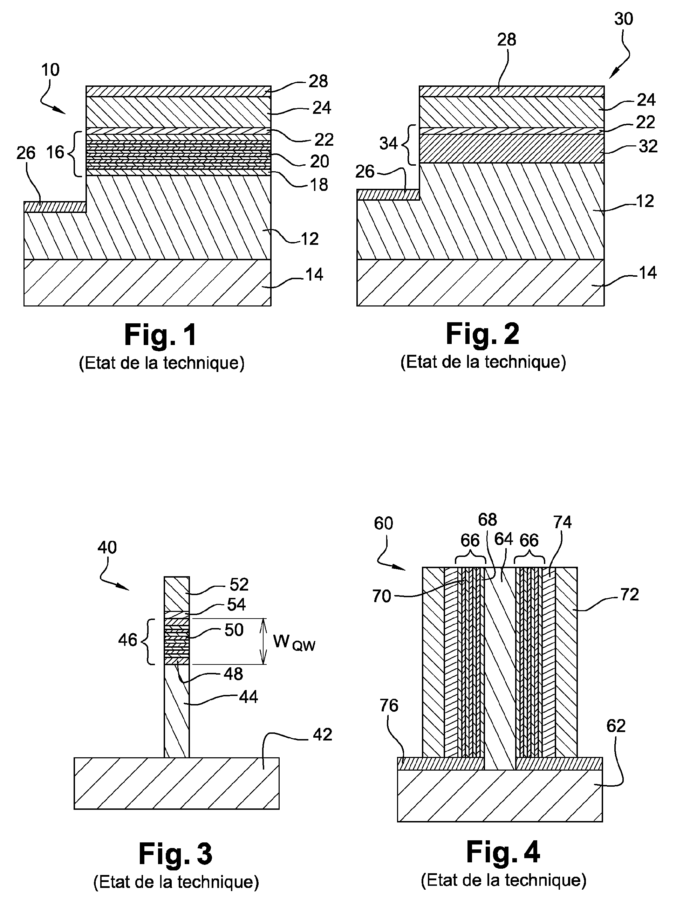

La technologie dite « planaire » est la technique couramment mise en oeuvre pour produire des dispositifs émetteurs de lumière, telle que les LED, à base de matériau III-V, et en particulier III-N, et II-VI, comme le GaN, le ZnO ou encore le GaAlAs par exemple, émettant dans le domaine spectral bleu ou pour la conversion en lumière blanche.
Une LED en technologie planaire est usuellement réalisée à partir d'épitaxies successives, notamment par MOCVD (pour *« Metal-Organic Chemical Vapour Deposition »*), de couches en matériaux semi-conducteurs de la famille III-N.
Ainsi, en se référant à la figure 1, qui est une vue schématique en coupe d'une LED planaire **10** de l'état de la technique, une couche de GaN **12,** dopée n par du silicium, est déposée sur un substrat de saphir **14.** Une couche active **16,** constituée de multi-puits quantiques formés d'une alternance de sous-couches de GaN **18** et de InGaN **20** non intentionnellement dopées, est déposée sur la couche de GaN dopée n **12.** Une couche bloqueuse d'électrons d'AlGaN dopée p **22,** communément désignée par couche « EBL » (pour *« Electron Blocking Layer »*), est par ailleurs déposée entre la couche active **16** et une couche de GaN **24** dopée p par du magnésium. Enfin, des contacts électriques inférieur **26** et supérieur **28** sont formés respectivement sur la couche **12** et sur la couche dopée p **24** pour la connexion électrique de la LED **10.**
Ainsi, des électrons, injectés dans la couche active **16** au moyen de la couche n **12,** et des trous, injectés dans la couche active **16** au moyen de la couche p **24,** se recombinent, au moins en partie, de manière radiative dans la couche active **16,** les multi-puits quantiques ayant une fonction de confinement, comme cela est connu en soi. De la lumière est ainsi émise par la couche active **16.**
La LED planaire à base de semi-conducteurs III-N et de puits quantiques, telle que précédemment décrite, souffre de limitations en termes de performances.
Tout d'abord se posent des problèmes d'injection électrique et de confinement électrique des porteurs.
En effet, d'une part, la mobilité des trous est très faible comparativement à la mobilité des électrons, et d'autre part les trous sont injectés en plus faible concentration que les électrons en raison de la difficulté à activer les atomes de magnésium, ici les accepteurs, dans la couche de GaN dopée p **24** et de la plus forte résistivité de la couche **24** par rapport à la couche **12.** La couche EBL **22** est donc nécessaire afin de localiser les recombinaisons radiatives des paires électrons-trous dans les puits quantiques InGaN/GaN.
La couche EBL **22** nécessite cependant d'être conçue avec le plus grand soin, notamment concernant ses bandes d'énergie, sa croissance hétéro-épitaxiale sur une couche **16,** et sa composition en matériau ternaire. En effet, une couche d'AlGaN mal conçue a pour effet de bloquer les trous injectés par la couche dopée p **24** et donc de rendre la LED **10** inefficace.
Ensuite se posent des problèmes d'efficacité quantique interne de la LED planaire **10.**
On observe une diminution importante de l'efficacité de la LED pour des densités de courant supérieures à 10 A/cm$^2$ en raison d'un phénomène connu sous le nom de « *Droop Efficiency* », ce qui écarte ainsi la LED de nombreuses applications nécessitant une forte densité de courant supérieure à 200 A/cm$^2$, comme par exemple les écrans ou les éclairages.
Plus particulièrement, le phénomène de « *Droop Efficiency* » est lié aux sources de pertes par recombinaison non radiatives des paires électrons-trous, au rang desquels il est possible de citer :

- la délocalisation des porteurs de charge hors des zones riches en indium dans les multi-puits quantiques InGaN/GaN ;
- les pertes dues aux dislocations et défauts ponctuels ;
- les pertes par effet thermique ;
- la polarisation piézoélectrique importante entre les hétéro-structures InGaN/GaN qui engendre une séparation spatiale des paires électrons-trous et l'apparition d'états d'interfaces ;
- les recombinaisons Auger, par des mécanismes directs ou assistés par phonons ; et
- l'injection inefficace des porteurs en raison de l'échappement des électrons hors des multi-puits quantiques et la faible concentration de trous dans ces puits.

Ces pertes sont d'autant plus importantes que la densité de porteurs est grande.

Afin de réduire le « *Droop Efficiency* », et donc augmenter la densité de courant applicable à une LED sans détérioration notable de son efficacité, il convient de réduire la densité des porteurs de charge dans la zone de recombinaison radiative des paires électrons-trous.

Pour ce faire, il a été proposé dans l'article de N.F. Gardner et al., « Blue-emitting InGaN-GaN double-heterostructure light-emitting diodes reaching maximum quantum efficiency above 200 A/cm2», Applied Physics Letters 91, 243506 (2007), de substituer les multi-puits quantiques, qui de par leur nature induisent un « *Droop Efficiency* » même pour de faibles valeurs de densité de courant, par une double hétéro-structure, telle que représentée sur la figure 2.

Comme illustré sur cette figure schématique en coupe d'une LED planaire **30,** les multi-puits quantiques InGaN/GaN sont ici remplacés par une unique couche d'InGaN non intentionnellement dopée **32,** qui forme avec les couches **12** et **22** une double hétéro-structure **34.**

Comparativement à la LED à multi-puits quantiques **10** de la figure 1, la LED à double hétéro-structure **30** présente une augmentation de l'efficacité pour des densités de courant élevée de l'ordre de 200 A/cm$^2$. En effet, l'augmentation du volume de matériau InGaN, dans lequel sont réalisées les recombinaisons des paires électrons-trous, a pour effet de diminuer la densité des porteurs de charge, principale cause du « *Droop Efficiency ».* Cette amélioration a ainsi été démontrée sur des dispositifs émettant autour de 440 nanomètres avec à une double hétéro-structure GaN/InGaN de 10nm d'épaisseur et contenant environ 14% d'indium.

Cependant, la LED planaire à double hétéro-structure **30** souffre elle aussi de limitations fondamentales.

Tout d'abord, on retrouve les problèmes génériques d'injection électrique et de rendement quantique interne limité propres aux LEDs planaires, à savoir que la couche EBL **22** est nécessaire, et pose donc les mêmes problèmes que précédemment décrits, et que le volume de la zone active **32** est réduit comparativement au volume total de la LED **30.** Ensuite, la double hétéro-structure **34,** si elle résout effectivement des problèmes inhérents à la structure sous forme de multi-puits quantiques, connaît des problèmes qui lui sont propres.

En effet, compte tenu de la grande différence de paramètre de mailles entre l'InGaN de la couche **32** et le GaN de la couche **12,** à savoir une différence d'environ 10%, il est difficile d'épitaxier du matériau InGaN avec une forte concentration d'indium et/ou de forte épaisseur. En effet, au delà d'une épaisseur appelée « épaisseur critique », des défauts cristallins apparaissent au sein du matériau InGaN, défauts qui provoquent une perte sensible du rendement quantique interne en raison des recombinaisons non radiatives qu'ils engendrent.

Ainsi pour obtenir une forte densité de courant dans la LED **30** en augmentant le volume d'InGaN, il convient d'avoir une faible composition en indium de la couche **32,** ce qui limite les longueurs d'ondes qu'il est possible d'émettre au spectre bleu.

La double hétéro-structure planaire introduit donc un antagonisme fort entre la longueur d'onde d'émission de la LED et la densité de courant possible sans perte d'efficacité.

Parallèlement à la technologie des LEDs planaires, on connaît des LEDs à base de nanofils InGaN/GaN, fabriquées également par croissance épitaxiale, notamment par épitaxie MBE (pour « *Molecular Beam Epitaxie* ») ou par épitaxie MOCVD.

On distingue dans l'état de la technique deux catégories de LEDs à base de nanofils :

- celles dont la zone active des nanofils comprend des structures de confinement à multi-puits quantiques épitaxiés axialement, c'est-à-dire selon l'axe de croissance des nanofils,
- et celles dont la zone active des nanofils comprend des structures de confinement à multi-puits quantiques épitaxiés radialement, c'est-à-dire dans un volume formé autour de l'axe de croissance des nanofils.

Sur la figure 3, il est représenté de manière schématique en coupe un exemple de nanofil **40** à multi-puits quantiques épitaxiés axialement. Le nanofil **40** est formé d'une zone en GaN dopée n **44** par du silicium, formée sur un substrat en silicium dopé n+ **42,** sur laquelle est formée une zone active **46** constituée de multi-puits quantiques axiaux formés d'une alternance de zones de GaN **48** et de zones InGaN **50** non intentionnellement dopées. Une zone de GaN **52,** dopée p par du magnésium, est par ailleurs déposée sur une zone EBL **54,** elle-même déposée sur la zone active **46.**

Selon cette géométrie axiale, les électrons et les trous sont injectés dans la zone active **46** respectivement au moyen du substrat **42** et de la zone **52,** et se recombinent, au moins en partie de manière radiative, dans la zone active **46.**

Sur la figure 4, il est représenté de manière schématique en coupe un exemple de nanofil **60** à multi-puits quantiques épitaxiés radialement sur un substrat en silicium dopé n+ **62.** Le nanofil **60** comporte un coeur **64** en GaN dopé n par du silicium, entouré d'une zone active **66** constituée de multi-puits quantiques radiaux formés d'une alternance de zones de GaN **68** et de zones InGaN **70** non intentionnellement dopées. Un volume EBL **74** entoure la zone active **66,** le volume EBL **74** étant lui-même entouré d'un volume de GaN dopé p **72** par du magnésium. Les zones **66, 74** et **72** sont par ailleurs formées sur une couche d'isolation électrique **76.**

Selon cette géométrie radiale, les électrons et les trous sont injectés dans la zone active **66** respectivement au moyen du substrat **62** et de la zone **72,** et se recombinent, au moins en partie de manière radiative, dans la zone active **66.**

Les nanofils, et plus particulièrement leur procédé de fabrication, présentent un certain nombre d'avantages, notamment :

- une croissance de nanofils sur substrats, chacun constitués d'un matériau désaccordé en paramètre de maille l'un par rapport à l'autre. Ainsi, le silicium, qui est un substrat à bas coût, fabricable à grande taille et conducteur, peut être envisagé pour la croissance de nanofils en matériau III-N, ce qui est impossible en technologie planaire. Cette alternative présente des avantages à la fois en termes de coût de production et de simplification des procédés de fabrication, notamment au niveau de l'injection électrique ;
- une bonne qualité cristalline due à la relaxation des contraintes aux surfaces libres. Ainsi on observe naturellement une diminution du nombre de centres de recombinaisons non-radiatifs par rapport aux structures planaires, et notamment une absence de dislocations traversantes ; et
- une meilleure extraction de la lumière sans complexification des procédés de fabrication.

D'autre part, les LED à base de nanofils sont moins limitées en termes de longueur d'onde à émettre que les LED planaires car on peut étendre la gamme de composition en alliage constituant la couche active.

Toutefois, les LEDs à base de nanofils venant d'être décrites souffrent elles aussi de limitations fondamentales.

Tout d'abord, quelle que soit la géométrie adoptée pour une LED à base de nanofils de l'état de la technique, une zone EBL est nécessaire pour confiner les porteurs. Ainsi, comme pour les LEDs planaires, une croissance parfaitement contrôlée à la fois en termes de morphologie, de composition, d'épaisseur et de dopage des semi-conducteurs III-N binaires et ternaires de la zone EBL est indispensable.

En outre, la zone active présente là encore un volume réduit par rapport au volume total du nanofil, ce qui implique une efficacité quantique interne limitée.

Enfin, les zones actives des LED à base de nanofils de l'état de la technique se présentent sous la forme de multi-puits quantiques. Ainsi, quand bien même on observerait un meilleur comportement de ces LED vis-à-vis du « *Droop efficiency* » par rapport aux diodes planaires à multi-puits quantiques de l'état de la technique, il n'en demeure pas moins que la présence des multi-puits quantiques implique une densité de courant limitée applicable aux LEDs avant une diminution sensible de leur efficacité.

On connait du document WO 2008/079077 A2 une LED à base de nanofils à coeur réalisé en un matériau semi-conducteur non intentionellement dopé.

On connaît également du document WO2009/106636 une LED à base de nanofils. Les nanofils, réalisés en ZnO de type n, sont épitaxiés sur une couche tampon en ZnO déposée sur substrat en silicium. Les nanofils de ZnO dopés n sont par ailleurs noyés dans une couche de polymère semi-conducteur dopé p, notamment du PEDOT/PSS et deux électrodes métalliques sont respectivement au contact de la couche tampon de ZnO pour l'injection d'électron et de la couche de polymère pour l'injection de trous. Il est ainsi obtenu une large surface de jonction p-n entre le ZnO de type n des nanofils et la couche polymère de type p en raison de la géométrie des nanofils.

Toutefois, le volume de matériau actif de ce type de LED, c'est-à-dire le volume de matériau dans lequel se recombinent de manière radiative les électrons et les trous, est très faible puisque ce volume se limite à l'interface des jonctions p-n formées des nanofils de type n et de la couche de polymère de type p.

Ainsi donc, il n'existe pas à ce jour de LED permettant à la fois d'avoir une densité de courant élevée, une efficacité quantique interne élevée et une grande liberté de choix quant à la longueur d'onde émise.

## EXPOSE DE L'INVENTION

Le but de la présente invention est de résoudre les problèmes susmentionnés en proposant un dispositif optoélectronique qui présente l'ensemble de ces avantages.

A cet effet, l'invention a pour objet un dispositif optoélectronique comportant :

- une zone semi-conductrice active pour la recombinaison radiative de paires électrons-trous réalisée sous la forme d'au moins un nanofil réalisé en un matériau semi-conducteur non intentionnellement dopé;
- une zone semi-conductrice pour l'injection radiale de trous dans le ou chaque nanofil, réalisée en un matériau semi-conducteur dopé d'un première type de conductivité et de bande interdite supérieure à la bande interdite du matériau constitutif du nanofil; et
- une zone semi-conductrice pour l'injection axiale d'électrons dans le ou chaque nanofil, réalisée en un matériau semi-conducteur dopé d'un second type de conductivité opposé au premier type de conductivité.

Par « injection axiale », il faut comprendre ici que l'injection des électrons dans la zone active est majoritairement réalisée selon la direction de croissance du nanofil. Par exemple, l'injection d'électrons se fait par la base du nanofil.

Par « injection radiale », on entend ici que l'injection des trous dans la zone active est majoritaire réalisée par la surface latérale du nanofil. Par exemple, la zone d'injection de trous enrobe la zone active au moins partiellement sur une partie de sa hauteur.

Par « non intentionnellement dopé », on entend ici un matériau semi-conducteur qui n'a pas subi de dopage extrinsèque et comprend au plus un dopage résiduel. Ce type de matériau est usuellement identifié par la lettre « i » par opposition aux matériaux extrinsèquement dopés « p » et « n ».

Dans ce qui suit, les expressions « dopé p » et « dopé n » se réfèrent à des dopages extrinsèques de matériaux semi-conducteurs.

En d'autres termes, le fait de prévoir l'injection axiale des électrons permet de libérer le coeur du nanofil pour la zone active qui représente alors l'essentiel du volume du nanofil. En effet, en raison de leur mobilité très élevée, les électrons occupent l'ensemble du volume de la zone active malgré la surface d'injection réduite.

Une hétérojonction est en outre utilisée afin de confiner spatialement les porteurs dans le nanofil, ce qui permet l'amélioration de l'efficacité quantique des dispositifs. Comme cela est connu en soi, une hétérojonction consiste à assembler côte à côte deux matériaux possédant des largeurs de bande interdite différentes. Une barrière est alors constituée par le matériau à large gap, ou « bande interdite », du matériau pour l'injection des trous alors que la zone active constituée du nanofil est quant à elle caractérisée par un gap plus petit. Ainsi, les porteurs injectés dans le nanofil sont confinés dans le nanofil du fait de la présence des barrières de potentiels. La forte densité de porteurs dans la zone active augmente ainsi leur taux de recombinaisons radiatives.

De plus, en raison de la nature non dopée du coeur du nanofil, il est obtenu une structure de type p-i-n. Le nanofil constitue donc un volume actif dans lequel se recombinent de manière radiative les électrons et les trous.

Ensuite, puisque le dispositif est à base de nanofils, il est possible d'obtenir un bon confinement des porteurs de charges tout en limitant leur concentration, source du *« Droop efficiency »* par un choix approprié de la hauteur des nanofils, comme cela sera expliqué plus en détail par la suite.

Ensuite, les nanofils n'étant pas sensibles au paramètre de maille, le choix de la hauteur des nanofils, notamment pour obtenir une densité de courant appropriée sans « *Droop efficiency* », est décorellé du choix de la composition du semi-conducteur constitutif de la zone active, par exemple la composition en indium dans le cas d'un dispositif à base de GaN. Le choix de la longueur d'onde d'émission est ainsi plus large. Il est ainsi possible de fabriquer des LED à base de nanofils émettant dans le spectre visible, notamment du rouge au bleu dans le cas d'une LED à base de GaN, voire même de réaliser une LED émettant une lumière blanche en variant la composition en indium lors de l'épitaxie du coeur du nanofil.

Par ailleurs, la zone active représentant l'essentiel du volume du nanofil, le dispositif selon l'invention présente un rendement quantique interne amélioré même à forte densité de courant d'injection.

Selon un mode de réalisation préféré de l'invention, la zone active est constituée d'un unique matériau semi-conducteur. Plus particulièrement, la zone active est constituée d'un matériau semi-conducteur de type III-V ou de type II-VI, et en particulier de type III-N.

En d'autres termes, le nanofil présente une structure du type à double hétéro-structure, ce qui permet une amélioration sensible de l'efficacité quantique interne.

En effet tout d'abord, le volume de matériau actif est largement augmenté par rapport à une structure à multi-puits quantiques. Ensuite, comme précédemment exposé, la zone active possède une bonne qualité cristalline, et ce malgré une grande hauteur de la zone active et/ou une forte composition en In par exemple.

En outre, la réduction du nombre d'hétéro-interfaces GaN/InGaN par rapport à une structure à multi-puits quantiques, ainsi que la relaxation des contraintes entre les matériaux de différents paramètres de maille (i.e. : InGaN / GaN), limitent les champs piézoélectriques à l'intérieur de la structure au niveau des hétéro-interfaces. Ainsi loin de ces interfaces, les bandes d'énergies sont peu affectées.

Selon une variante de l'invention :

- la zone active est constituée d'InGaN non intentionnellement dopé ;
- la zone dopée p est constituée de GaN dopée p ou de InGaN dopé p de concentration en In inférieure à celle de la zone active ; et
- la zone dopée n est constituée de Si dopé n ou de GaN dopé n.

Dans une LED à base de GaN, la zone active est constituée d'InGaN, alors que la barrière est formée de GaN. En effet, l'incorporation d'In permet de diminuer simplement le gap de la zone active selon la formule :

$$Eg_{In_xGa_{(1-x)}N}(x) = Eg_{InN}x + Eg_{GaN}(1-x) - 1.4x(1-x)$$

$$Eg_{In_xGa_{(1-x)}N}(x) = 0.69x + 3.5(1-x) - 1.4x(1-x)$$

Par exemple, pour un alliage InGaN contenant 10% d'In, le gap du matériau est de l'ordre de 3,1 eV, alors que celui du GaN est égal à 3,5 eV.

Selon une variante de l'invention, la hauteur de la zone active présente une valeur minimale sélectionnée selon la relation :

$$F.J_{overflow} = \left(\frac{4.N_C}{3.\sqrt{\pi}}\right)^2 . \left(\frac{E_F - E_C}{k.T}\right)^3 . e.B.W_{DH}$$

où F est le facteur de remplissage des nanofils, $J_{overflow}$ est la densité de courant maximale supportée par les nanofils sans saturation en électrons, $N_C$ est la densité d'états effective de la bande de conduction du matériau, e est la charge élémentaire, B est le coefficient de recombinaison bimoléculaire du matériau, et $W_{DH}$ est la valeur minimale de la hauteur de la zone active.

En d'autres termes, en choisissant une hauteur de zone active suffisante c'est-à-dire supérieure à la valeur donnée dans la relation ci-dessus, on s'assure que le dispositif peut supporter une densité de courant de valeur au plus $J_{overflow}$ sans pertes.

Selon une variante de l'invention, la zone active est réalisé en InGaN, et :

- les nanofils ont une densité comprise entre $10^8$ et $10^{10}$ par centimètre carré ;
- les nanofils ont un diamètre compris entre 50 nanomètres et 500 nanomètres ; et
- la hauteur de la zone active des nanofils est comprise entre 40 nanomètres et 5 micromètres.

Plus particulièrement, pour supporter des densités de courant macroscopiques de 200 A/cm$^2$, si les nanofils ont une densité de $4.10^9$ cm$^{-2}$, un diamètre de 100 nanomètres, l'épaisseur minimale de la zone active est de 40 nanomètres afin d'éviter les pertes par « débordement » (overflow en anglais).

Selon un mode de réalisation de l'invention, il n'y a pas de zone bloqueuse d'électron entre la zone active et la zone dopée p, facilitant ainsi la conception du dispositif.

Selon un mode de réalisation de l'invention, les nanofils sont formés sur un substrat en matériau semi-conducteur dopé n, et la zone active du nanofil repose sur le substrat, le substrat formant la zone d'injection d'électrons. La fabrication des nanofils se résume donc ici à la croissance de la zone active sur un substrat, suivi du dépôt d'une couche dopée p sur les extrémités libres des nanofils.

Selon un autre mode de réalisation, le nanofil comporte une base en semi-conducteur dopé n pour l'injection d'électrons. En variante, les nanofils sont formés sur substrat qui comporte une couche continue de matériau semi-conducteur dopé n, de la même famille que le matériau constitutif de la zone active, et sur laquelle reposent les nanofils, ladite couche continue formant la zone pour l'injection d'électrons.

En d'autres termes, la base en semi-conducteur dopé n des nanofils et la couche continue dopé n permettent un choix plus large de matériaux pour le substrat.

Selon un mode de réalisation de l'invention, les nanofils sont formés sur un substrat, et la zone dopée p enrobe partiellement la portion des nanofils opposée au substrat, notamment la partie haute des nanofils. Plus particulièrement, la zone dopée p enrobe moins des trois quarts de la périphérie des nanofils.

En laissant ainsi une partie de la surface périphérique de la zone active libre, l'indice optique moyen de la couche émettrice de lumière du nanofil est diminué, ce qui améliore l'efficacité d'extraction de lumière du dispositif.

Selon un mode de réalisation de l'invention, la zone pour l'injection de trous forme une couche de matériau planarisante, ce qui facilite le dépôt ultérieur d'un contact ohmique.

## BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques, et dans lesquels :

- la figure 1 est une vue en coupe schématique d'une LED planaire à multi-puits quantiques de l'état de la technique, telle que décrite dans le préambule ;

- la figure 2 est une vue en coupe schématique d'une LED planaire à double hétéro-structure de l'état de la technique, telle que décrite dans le préambule ;
  - la figure 3 est une vue en coupe schématique d'un nanofil de LED à multi-puits quantiques axiaux de l'état de la technique, tel que décrit dans le préambule ;
  - la figure 4 est une vue en coupe schématique d'un nanofil de LED à multi-puits quantiques radiaux de l'état de la technique, tel que décrit dans le préambule ;
  - la figure 5 est une vue en coupe schématique d'un nanofil de LED selon un premier mode de réalisation de l'invention ;
  - la figure 6 est un tracé de la densité de courant maximale de courant sans "overflow" dans la LED de la figure 5 ;
  - les figures 7 à 9 sont des vues schématiques en coupe illustrant un procédé de fabrication de la LED de la figure 5 ;
  - les figures 10 à 12 sont des vues schématiques en coupe illustrant un procédé de fabrication d'une LED selon un second mode de réalisation de l'invention ;
  - les figures 13 à 15 sont des vues schématiques en coupe illustrant un procédé de fabrication d'une LED selon un troisième mode de réalisation de l'invention ;
  - les figures 16 et 17 sont des vues schématiques en coupe illustrant une variante de fabrication d'une LED selon l'invention ; et
  - la figure 18 est une vue schématique en coupe d'un nanofil de LED selon une variante de l'invention.

## DESCRIPTION DETAILLEE DE L'INVENTION

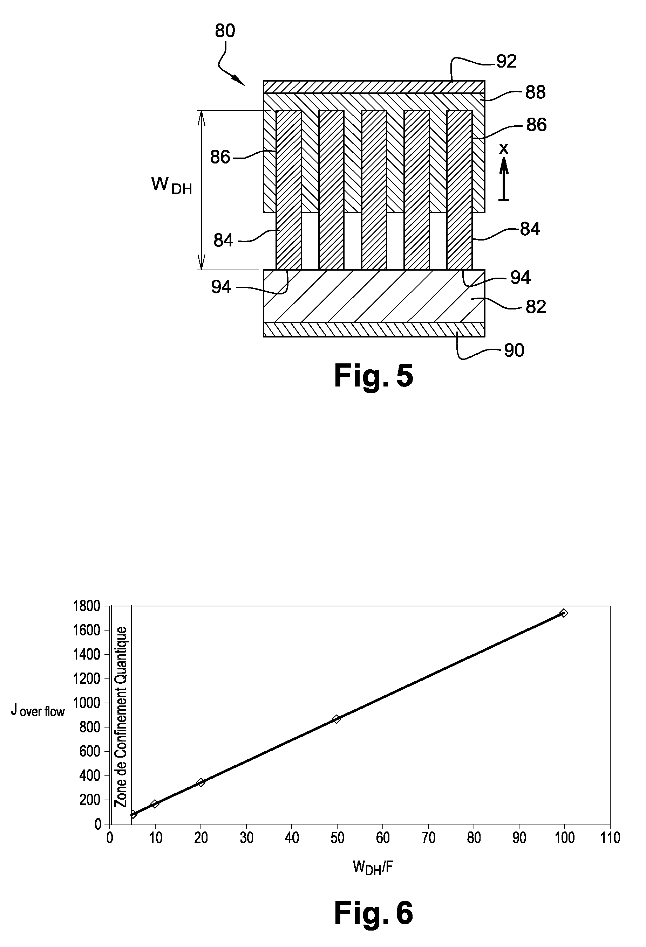

En se référant à la figure 5, une LED **80** selon un premier mode de réalisation de l'invention comporte un substrat de silicium de type n **82,** sur lequel sont formés des nanofils **84** en matériau semi-conducteur non intentionnellement dopé de la famille III-V ou II-VI, préférentiellement de la famille III-N. Les nanofils **84** sont enrobés dans leur partie supérieure **86** par une couche planarisante **88** en matériau dopé p de la même famille que celle du matériau des nanofils **84,** mais présentant un gap d'énergie supérieur de manière à permettre l'injection de trous depuis la couche **88** vers les nanofils **84.** La couche **88** est par ailleurs isolée du substrat **82** afin d'éviter un court circuit. Par exemple, la couche **88** s'arrête au dessus du substrat **82.** Enfin, des contacts ohmiques supérieur **92** et inférieur **90** sont formés respectivement sur la couche **88** et sous le substrat **82.**

La LED **80** fonctionne de manière classique : les électrons sont injectés dans un nanofil **84** via le substrat **82** et les trous sont injectés dans le nanofil **84** via la couche **88.** Les paires électrons-trous injectés se recombinent donc, au moins partiellement de manière radiative, dans le nanofil **84** qui constitue une zone active.

On notera donc que la LED **80** présente une structure du type à double hétéro-structure puisqu'il existe pour chaque nanofil **84** une première hétéro-structure formée du nanofil **84** et du substrat **82,** et une seconde hétéro-structure formée du nanofil **84** et de la couche **88.**

Comme précédemment décrit, le fait que l'injection des électrons soit réalisée axialement, dans l'exemple par la base du nanofil, n'est pas restrictif du point de vue de l'injection électrique en raison de la grande mobilité des électrons. En outre, tout point du nanofil **84,** c'est-à-dire de la zone active, se trouve à une distance inférieure ou égale au rayon du nanofil. La surface d'injection des trous est donc à la fois très grande et très proche de chaque point de la zone active.

Le substrat **82** est sélectionné de manière à présenter une résistivité faible, notamment de l'ordre de 0,001 ohm/cm, afin de faciliter l'injection d'électrons dans les nanofils **84,** et est par exemple constitué de Si dopé n+ d'une épaisseur de 400 nanomètres. Ce substrat peut d'autre part supporter l'épitaxie des nanofils de GaN.

Par ailleurs, tout type de matériau semi-conducteur pouvant être modulé en énergie et épitaxié sous forme de nanofils peut entrer dans la constitution des nanofils **84** et de la couche dopée p **88.**

Avantageusement, la LED **80** est réalisée à base de GaN : les nanofils **84** sont constitués de InGaN non intentionnellement dopés, et comportant un dopage n résiduel inférieur à $10^{16}$ électrons/cm$^3$, dont la composition en indium est choisie en fonction de la longueur d'onde à émettre par la LED **80.** La couche planarisante **88** est constituée de GaN dopée p par du magnésium, ou de InGaN dopé p par du magnésium de composition en indium inférieure à celle des nanofils **84,** le matériau de la couche **88** présentant une concentration de porteurs p de l'ordre de $10^{18}$ trous/cm$^3$.

En variante, la LED **80** est réalisée à base de ZnO : les nanofils **84** sont constitués de ZnO non intentionnellement dopé et la couche **88** dopée p est constituée de ZnMgO, ou bien les nanofils sont constitués de ZnCdO non intentionnellement dopé et la couche **88** est constituée de ZnO. En variante encore, la LED **80** est réalisée à base de GaAlAs, les nanofils **84** sont constitués de GaAs non intentionnellement dopé et la couche **88** dopée p est constituée de GaAlAs, ou bien les nanofils sont constitués de InGaAs non intentionnellement dopé et la couche **88** est constituée de GaAs. En variante encore, la LED **80** est réalisée à base de AlInGaP, les nanofils **84** sont constitués de AlGaInP non intentionnellement dopé et la couche **88** est constituée du même matériau mais avec une composition plus forte en aluminium.

Le contact supérieur **92,** qui délimite spatialement la taille macroscopique de la LED **80,** par exemple un carré de 1mm$^2$, peut quant à lui être constitué de différents empilements, comme par exemple un contact semi-transparent fin en alliage de Ni et d'Au, ou bien en oxyde d'indium-étain (ou ITO pour *«Indium Tin Oxyde »*), recouvert d'un peigne épais, par exemple en alliage de Ni et d'Au pour diminuer sa résistance série.

Le contact inférieur **90** est déposé sur la totalité de la face inférieure du substrat et est par exemple constitué d'un alliage de NiSi recouvert d'Au.

Grâce à son architecture en nanofil, réalisable quel que soit le type de matériau semi-conducteur choisi en raison du peu d'influence du paramètre de maille, il existe un large choix quant à la longueur d'onde émise par la LED **80**.

En faisant l'hypothèse de nanofils **84** cylindriques, le facteur de remplissage F, égal au ratio entre l'aire totale des bases des nanofils sur l'aire du substrat **82,** peut être calculé selon la relation :

$$F = \frac{\pi}{4}.d^2.d_n$$

où :

- d est le diamètre des nanofils **84 ;** et
- $d_n$ est la densité surfacique des nanofils **84,** exprimée en nombre de nanofils par $cm^2$.

En fixant le diamètre d des nanofils à 100 nm et leur densité à $4.10^9 cm^{-2}$, le facteur F est alors égal à 0,314. Ce facteur F permet de pondérer la densité de courant macroscopique afin de prendre en compte la différence entre l'aire du dispositif et la somme des aires de la base des nanofils.

En raison du peu d'influence du paramètre de maille, il est possible de vérifier que la hauteur de la zone active des nanofils **84** en fonction de la densité de courant souhaitée $J_{overflow}$ soit suffisante pour éviter tout phénomène d'overflow (ou phénomène de « débordement »).

Plus particulièrement, pour des nanofils constitués d'un matériau semi-conducteur supposé dégénéré tel que $\frac{E_F - E_C}{k.T} \geq 5$, c'est à dire sous forte injection électrique, dont la hauteur est $W_{DH}$ (i.e. la hauteur de la zone active), la valeur minimale $J_{overflow}$ de la densité de courant avant d'obtenir une saturation des états dans la zone active (ou courant de « débordement », tout courant supplémentaire ne voyant alors pas la zone active) est obtenue selon la relation:

$$F.J_{overflow} = \left(\frac{4.N_C}{3.\sqrt{\pi}}\right)^2 . \left(\frac{E_F - E_C}{k.T}\right)^3 .e.B.W_{DH}$$

où :

- F est le facteur de remplissage des nanofils **84** ;
- $N_C$ est la densité effective d'états de conduction dans la bande de conduction du matériau des nanofils **84 ;**
- $E_F$ et $E_C$ sont respectivement les niveaux d'énergie de Fermi et de conduction du matériau des nanofils **84 ;**
- k est la constante de Boltzmann ;
- T est la température de jonction (température de la zone active) des nanofils **84 ;**
- e est la charge élémentaire ; et
- B est le coefficient de recombinaison bimoléculaire du matériau des nanofils **84.**

Une hauteur minimale $W_{DH}$ des nanofils **84** sélectionnée de cette manière a pour effet que lorsqu'une densité de courant $J_{overflow}$ est injectée dans les nanofils **84,** le niveau de Fermi de la double hétéro-structure atteint le sommet de la barrière d'énergie séparant les niveaux d'énergie $E_F$ et $E_C$. La densité des porteurs de charge dans les nanofils **84** est alors maximale, toute augmentation supplémentaire de la densité de courant n'entrainant pas d'augmentation de la densité des porteurs de charge, puisque ces derniers s'échappent des nanofils **84** sans se recombiner. En d'autres termes, pour toute valeur de densité de courant inférieure ou égale à $J_{overflow}$, les porteurs ne s'échappent pas des nanofils **84,** de sorte que le phénomène de « *Droop Efficiency* » est diminué.

La figure 6 est un tracé de la valeur $J_{overflow}$ en fonction du ratio $\frac{W_{DH}}{F}$ pour des nanofils 84 en InGaN avec une composition en indium de 15%, pour lequel :

- Nc = $10^{18}$ cm$^{-3}$;

- $E_F - E_C = 150$ meV ;
- $B = 10^{-11}$ cm$^3$.s$^{-1}$;
- et T est la température de jonction.

Il est intéressant de noter que la valeur $J_{overflow}$ est directement proportionnelle au ratio $\dfrac{W_{DH}}{F}$, et donc à l'épaisseur de la zone active, c'est-à-dire la hauteur $W_{DH}$ des nanofils, pour un facteur de remplissage F donnée. Ceci est vrai dans le cas de non confinement quantique, c'est-à-dire pour un ratio $\dfrac{W_{DH}}{F}$ supérieur à 5 nm. Dans le cas des puits quantiques, la quantification des niveaux d'énergie rend encore plus critique l'augmentation de la densité de courant sur l'échappement des porteurs.

Compte tenu des densités de courant de fonctionnement souhaitées pour les LEDs, typiquement des densités supérieures ou égales à 200 A/cm2, on peut fixer le ratio $\dfrac{W_{DH}}{F}$ minimum à 15nm sans avoir une chute importante du rendement quantique interne de la LED **80**.

Par ailleurs, afin d'assurer son rôle de structure de confinement de manière efficace, la hauteur maximale des nanofils **84** est choisie inférieure à la longueur de diffusion des porteurs. Une hauteur maximale des nanofils **84** de quelques microns permet d'obtenir un confinement efficace.

Des nanofils **84** dont la hauteur minimale est de 40 nm, et dont la hauteur maximal n'excède pas quelques micromètres permettent donc à la fois d'assurer un bon confinement des porteurs de charge tout en évitant la chute du rendement quantique interne en raison des pertes par échappement des porteurs hors de la zone active.

Plus particulièrement, pour les nanofils en InGaN précédemment décrits, une densité de courant supérieure ou égale à 200 A/cm$^2$ avant le *« Droop Efficiency »* est obtenue. Plus généralement, cette caractéristique est atteinte pour des nanofils **84** en InGaN ayant un ratio $\dfrac{W_{DH}}{F}$ supérieur à 5 nanomètres, ou ayant:

- une densité surface $d_n$ comprise entre $10^8$ et $10^{10}$, par exemple une densité de $4.10^9$cm$^{-2}$;
- les nanofils ont un diamètre d compris entre 50 nanomètres et 500 nanomètres, par exemple un diamètre de 100 nanomètres ; et
- la hauteur de la zone active des nanofils est comprise entre 40 nanomètres et 5 micromètres.

La structure de nanofils de la LED **80** permet également un gain du rendement quantique interne par rapport à l'état de la technique en raison du volume élevé des zones actives qui forment le coeur des nanofils **84**.

Par exemple, en comparant la LED **80** selon l'invention à la LED **40** à base de nanofils à multi-puits quantiques axiaux décrite à la figure 3, et en fixant un même diamètre de nanofils pour ces LED ainsi qu'une même densité surfacique, le rapport du volume $V_1$ de la zone active dans la LED **80** sur le volume $V_2$ de la zone active dans la LED **40** est égal à :

$$\frac{V_1}{V_2} = \frac{W_{DH}}{n W_{QW}}$$

où :

- n est le nombre de puits quantiques dans la LED **40,** et
- $W_{QW}$ est la dimension axiale des multipuits quantiques au sein de la zone active **46**.

Le tableau 1 ci-dessous détaille la valeur du rapport $V_1/V_2$ dans différentes configurations :

- LED **80** dont la zone active a une hauteur $W_{DH}$ de 1 $\mu$m ou de 100 nanomètres ; et
- LED **40** contenant cinq puits quantiques pour une épaisseur $W_{QW}$ égale à 2,5 nanomètres.

Le tableau 1 détaille également plusieurs rapports $V_1/V_2$ selon plusieurs hypothèses concernant le fonctionnement réel de la LED **40** à multi-puits quantiques, à savoir :

- hypothèse 1 : les recombinaisons radiatives des paires électrons-trous se produisent dans la totalité du volume de la zone active **46** des nanofils ;
  - hypothèse 2 : l'épaisseur de la zone dans laquelle les recombinaisons radiatives ont lieu ne dépasse pas 1nanomètres, pour 2,5 nanomètres d'épaisseur réelle. Cette hypothèse repose sur les résultats de la publication N.F. Gardner et al., « *Blue-emitting InGaN-GaN double-heterostructure light-emitting diodes reaching maximum quantum efficiency above 200 A/cm2*», Applied Physics Letters 91, 243506 (2007) qui démontrent cette réduction de l'épaisseur effective de la zone active à cause de la présence d'intenses champs piézoélectriques internes ; et
  - hypothèse 3 : les recombinaisons radiatives ont lieu uniquement dans le puits quantique situé le plus proche de la zone d'injection de trous **52,** comme cela est le cas des structures LEDs planaires à multi-puits quantiques InGaN/GaN.

**Tableau 1**

|  | Hypothèse 1 : | Hypothèse 2 : | Hypothèse 3 : |
|---|---|---|---|
| $W_{DH} = 1\mu m$ $W_{SQ} = 2,5\ nm$ | **80** | **200** | **1000** |
| $W_{DH} = 100nm$ $W_{SQ} = 2,5\ nm$ | **8** | **20** | **100** |

Il apparaît donc clairement à la vue de ce tableau que le volume de matériau actif est largement augmenté dans la LED selon l'invention, de 8 à 1000 fois selon les l'hypothèse retenue. Par conséquent, le rendement quantique interne de la LED **80** est grandement amélioré par rapport une LED à base de nanofils à multi-puits quantiques axiaux.

De même, en comparant la LED **80** selon l'invention à la LED **60** à base de nanofils à multi-puits quantiques radiaux décrite à la figure 4, et fixant le diamètre hors zone d'injection de trous identique pour les deux LED ainsi que leur densité surfacique en nanofils, le rapport du volume $V_1$ de la zone active dans la LED **80** sur le volume $V_3$ de la zone active dans la LED **60** est égal à :

$$\frac{V_1}{V_3} = \frac{\pi.R_1^{\,2}.L_1}{2.\pi.R_3.L_3.n.W_{QW}}$$

où :

- $R_1$ est le rayon des nanofils **84** de la LED **80** selon l'invention ;
- $L_1 = W_{DH}$ est la longueur des nanofils **84 ;**
- $R_3$ est le rayon du coeur des nanofils dans la LED **60** à base de nanofils à multi-puits quantiques radiaux, c'est-à-dire le rayon sans la zone **72 ;**
- L3 est la hauteur des nanofils dans la LED **60 ;**
- $W_{QW}$ est l'épaisseur des multi-puits quantiques dans la la LED **60,** c'est-à-dire l'épaisseur du cylindre formé de la zone active **66** de la LED **60 ;** et
- N est le nombre de puits quantiques dans la LED **60.**

Le tableau 2 détaille différents rapports $V_1/V_3$ pour :

- $R_1 = R_3 = R = 50$ nm
- L1 = L3
- n = 5 et
- $W_{QW} = 2,5$ nm
- ainsi que pour les hypothèses quant au fonctionnement réel de la LED **60** telles que précédemment décrites.

**Tableau 2**

|  | Hypothèse 1 : | Hypothèse 2 : | Hypothèse 3 : |
|---|---|---|---|
| $R = 50nm$ | **2** | **5** | **25** |

Là encore, on observe une augmentation sensible du gain en volume, et donc du gain en rendement quantique interne de la LED **80** par rapport à la LED **60.**

On notera par ailleurs, que comparativement à la LED planaire à double hétéro-structure **30** décrite à la figure 2, pour obtenir le même volume total de matériau InGaN dans la LED **80** il suffit de prévoir une hauteur $W_{DH}$ des nanofils **84** 1/F fois supérieur à l'épaisseur de la couche **32** de la LED **30.** Par exemple, lorsque ladite épaisseur est égale à 10 nanomètres, comme exposé dans l'article de Gardner et al., cela équivaut à une hauteur $W_{DH}$ égale à environ 30 nanomètres pour des nanofils ayant un diamètre égal à 100 nanomètres de diamètre et de densité surfacique égale à $4.10^9 cm^{-2}$, soit une épaisseur $W_{DH}$ inférieure à la hauteur minimale de 40 nanomètres des nanofils telle qu'exposée précédemment.

Ainsi donc dans les trois cas considérés ci-dessus, il apparait clairement que la LED selon l'invention comporte une zone active de volume plus important que celle de l'état de la technique.

Cette propriété génère à la fois une augmentation du rendement quantique interne en raison de la plus grande quantité de matériau actif, ainsi qu'une diminution du « *Droop Efficiency* ». En effet, ce phénomène étant lié en partie à l'effet Auger, comme la densité de porteurs dans la zone active est inversement proportionnelle au volume de la zone active et que l'effet Auger varie comme le cube de cette même densité, alors un volume de zone active plus important implique une forte baisse des recombinaisons non-radiatives associées et donc une augmentation du rendement radiatif.

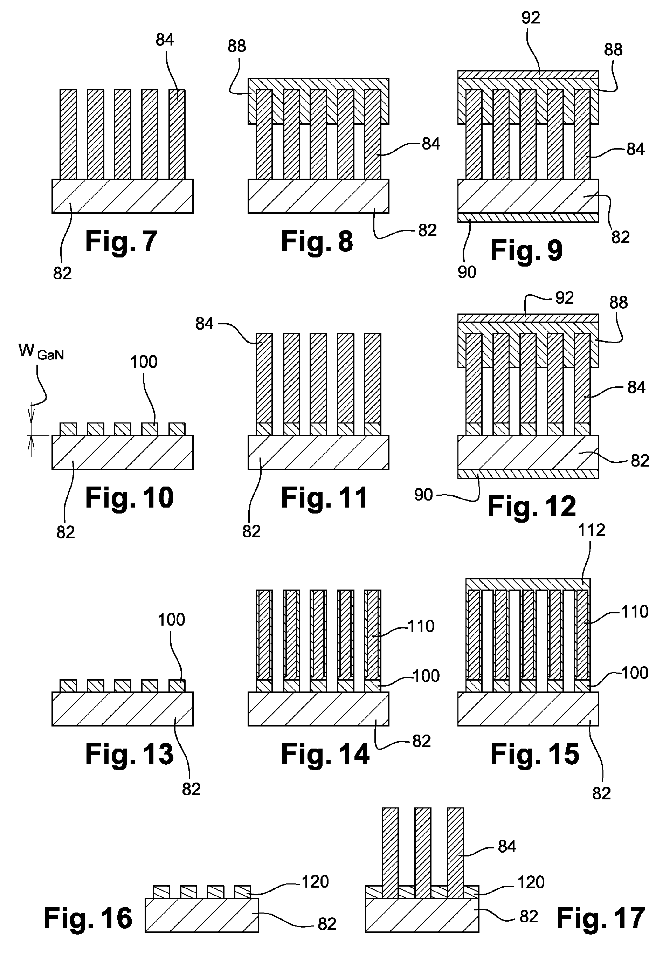

Il va à présent être décrit en relation avec les figures 7 à 9 un procédé de fabrication d'une LED **80** à base de InGaN.

Le procédé débute par la formation d'un substrat **82** semi-conducteur de type n de résistivité de l'ordre de 0,001ohm/cm, par exemple du silicium dopé n+ de 2 pouces et d'environ 400 micromètres d'épaisseur.

Puis, une hétéro-épitaxie d'InGaN épais est réalisée sur le substrat **84** afin d'obtenir des nanofils **84** d'une hauteur comprise entre 40 et 1000 nanomètres, et d'un diamètre compris entre 50 et 500 nanomètres, par exemple d'un diamètre de 100 nanomètres (figure 7).

La croissance des nanofils est réalisée par exemple par MOCVD, par MBE ou par HVPE (pour « *Hydride Vapour Phase Epitaxy* ») selon un mode dit spontané ou de façon sélective. Aucun dopant n'est utilisé au cours de la croissance de l'InGaN qui présente alors un dopage résiduel inférieur à $10^{16}$ électrons/$cm^3$.

Le procédé se poursuit alors par la croissance épitaxiale d'une couche **88** en GaN ou InGaN dopée p à la surface et en périphérie des nanofils **84** (figure 8), la morphologie de la couche **88** étant contrôlée grâce aux conditions de croissance.

La concentration de porteurs p dans la couche **88,** par exemple apportés par un dopage en magnésium, est choisi de l'ordre de $10^{18}$ trous/$cm^3$, et la composition d'indium est soit nulle (GaN-p), ou si elle est différente de 0, inférieure à celle de l'InGaN épais des nanofils **84** pour assurer le confinement des porteurs, puisque l'ajout d'indium dans la zone active attire les porteurs.

De manière avantageuse, une partie des nanofils en InGaN est laissée libre, et reste donc entourée d'air, afin de minimiser l'indice optique du milieu et ainsi améliorer l'efficacité d'extraction du dispositif, et dans tous les cas la couche **88** est réalisée de manière à ne pas venir en contact avec le substrat **82** afin d'éviter tout court circuit.

On notera qu'il est connu de l'état de la technique qu'un changement des paramètres de croissance permet de passer d'une croissance verticale à une croissance horizontale. On pourra par exemple se référer à la croissance ELOG (pour « *Epitaxy Latéral OverGrowth* »), telle que par exemple décrit dans l'article de Kaponek et al [APL **71**, 1204 (1997)]. Dans une première variante, en changeant les paramètres de croissance, on favorise la croissance latérale de la couche p au détriment de la croissance verticale jusqu'à obtenir coalescence des nanofils et dans ce cas la couche **88** p est dite planarisante, simplifiant ainsi le dépôt du contact électrique supérieur.

Dans une seconde variante, la couche **88** n'est pas planarisante, et une étape de planarisation de cette couche est mise en oeuvre, par exemple telle que décrite le document WO 2009/087319.

Des contacts ohmiques inférieur **92** et supérieur **90** sont ensuite respectivement déposés sous le substrat **82** et sur la couche **88** (figure 9).

Le contact p supérieur **92** délimite spatialement la taille du dispositif et peut être constitué de différents empilements, comme l'empilement d'un contact semi-transparent en alliage Ni/Au ou ITO et d'un peigne plus épais en alliage Ni/Au pour diminuer la résistance série du contact, tel que cela est décrit pas exemple dans le document WO 2009/087319.

Le dépôt du contact n inférieur **90** sur la face arrière du silicium ne pose pas de problème particulier et peut par exemple être constitué d'un siliciure de nickel.

Selon une variante de l'invention, une couche de GaN de type p est intercalée par épitaxie entre les nanofils **84** d'InGaN et le substrat **82,** ce qui permet un choix plus libre de matériau pour ce dernier.

Un second mode de réalisation est à présent décrit en relation avec le procédé de fabrication illustré aux figures 10 à 12.

Ce second mode de réalisation diffère du premier mode de réalisation précédemment décrit aux figures 7 à 9 en ce que, préalablement à la croissance des nanofils en InGaN **84,** des nanofils en GaN **100,** dopés n, notamment par du Si, sont épitaxiés sur le substrat **82** sur une faible épaisseur $W_{GaN}$, par exemple une épaisseur de 100 nanomètres, et avec une concentration en porteurs n proche de $10^{18}$ ou $10^{19}$ porteurs/cm$^3$ (figure 10). Les nanofils **84** sont alors épitaxiés sur les nanofils en GaN dopés n **100,** ce qui forment un ensemble de nanofils GaN/InGaN (figure 11). Le procédé se poursuit alors de la manière décrite précédemment pour l'obtention d'une LED à base de nanofils à double hétéro-structure (figure 11).

La base des nanofils en GaN dopé n permet un choix plus large pour le substrat **82,** qui peut par exemple être constitué de silicium comme pour le premier mode de réalisation, ou bien être un substrat métallique constitué par exemple de cuivre, d'un alliage à base de Ni et de Molybdène. La faible dimension des nanofils permet d'obtenir, à la base des nanofils, du GaN de type n qui présente de meilleures propriétés cristallines comparativement à l'utilisation d'une couche Buffer.

Un troisième mode de réalisation est à présent décrit en relation avec le procédé de fabrication illustré aux figures 13 à 15.

Le procédé débute par la réalisation d'un substrat **82** et de nanofils en GaN dopés n **100,** tel que cela a été décrit précédemment (figure 13). Ensuite, une croissance épitaxiale MBE de nanofils de InGaN **110** est mise en oeuvre sur les nanofils **100.** Du magnésium est incorporé dans le InGaN au cours même de la croissance des nanofils **110.** On observe alors un mécanisme de relaxation entrainant la formation spontanée, par une séparation de phases, d'une structure dite en « coeur/coquille », dans laquelle un coeur InGaN non dopé se forme et est entouré d'une coquille externe en GaN dopé n par le magnésium (figure 14). On obtient ainsi une augmentation de la surface du volume InGaN en contact avec le volume de GaN dopé p.

Le procédé se poursuit alors par la croissance et la coalescence d'une couche de GaN dopée p **112** à l'extrémité libre des nanofils **110** (figure 15), puis des contacts ohmiques sont déposés, optionnellement après une étape de planarisation, telle que décrite précédemment en relation avec le premier mode de réalisation.

Les figures 16 et 17 illustrent une variante de fabrication applicable à tous les procédés de fabrication venant d'être décrits.

Notamment dans cette variante, un masque de croissance **120** en matériau électriquement isolant et inerte vis-à-vis de la croissance épitaxiale de GaN ou de InGaN, tel que par exemple un masque en nitrure de silicium ou en silice, est déposé sur le substrat **82** (figure 16). Le procédé se poursuit alors par la réalisation de nanofils **84** en InGaN ou de nanofils GaN/InGaN tel que précédemment décrit (figure 17), puis de la couche en GaN dopé p et des contacts ohmiques. Cette variante de fabrication permet de contrôler avec précision le diamètre des nanofils ainsi que l'espacement entre ceux-ci de manière à optimiser l'efficacité d'extraction de la lumière produite par la LED.

Selon un autre mode de réalisation, la composition en indium des nanofils varie en fonction de la hauteur de ceux-ci. Par exemple, la composition en Indium augmente tout au long du fil. Cette configuration peut diminuer les contraintes mécaniques au sein du matériau par adaptation progressive du paramètre de maille

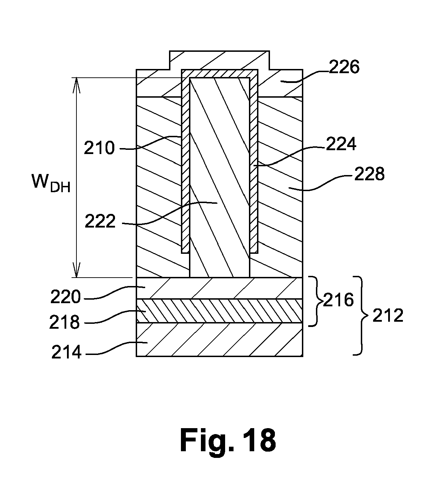

Une variante de réalisation de l'invention est décrite en relation avec la vue schématique en coupe de la figure 18. Sur cette figure, une nano-LED **210** est formée sur une portion d'un support **212** comprenant un substrat isolant **214** commun, sur lequel est déposée une couche conductrice d'électricité **216,** par exemple métallique ou semi-conductrice dopée.

En variante, la couche **216** comporte une première couche conductrice d'électricité **218** déposée sur le substrat **214** et sur laquelle est formée une couche **220** de GaN de type n.

La portion de support **212** est par exemple constituée d'un métal ou d'un semi-conducteur dopé.

La nano-LED **210** comporte un coeur **222** réalisé en un matériau semi-conducteur de la famille III-V ou II-VI, préférentiellement de la famille III-N. Le coeur **222** est enrobé au moins sur sa partie supérieure par une coquille **224** réalisée en un matériau semi-conducteur dopé p de la même famille que celle du matériau du coeur **222,** mais présentant un gap d'énergie supérieur de manière à permettre l'injection de trous depuis la coquille **224** vers le coeur **222.**

La coquille **224** est de préférence isolée du support **212** afin d'éviter tout court circuit entre un contact électrique supérieur **226** et la couche conductrice inférieure **216.** Par exemple, la coquille **224** s'arrête au dessus du support **212.**

Enfin, la nano-LED **210** est noyée dans une couche isolante et planarisante **228,** sauf en ce qui concerne sa tête, et le contact électrique supérieur **226** formé sur la couche planarisante **228.**

Le contact électrique supérieur **226** est semi-transparent à la longueur d'onde d'émission de la nano-LED **210** et peut être constitué de différents empilements, comme par exemple un contact semi-transparent constitué de fines couches de Ni et d'Au, ou bien en oxyde d'indium-étain (ou ITO pour *«Indium Tin Oxyde »*). Il peut être recouvert localement d'un peigne épais, par exemple des couches plus épaisses de Ni et d'Au pour diminuer sa résistance série.

Il vient d'être décrit des procédés dans le cas d'une LED à base de GaN. Bien entendu, d'autres types de matériau peuvent être utilisés.

**Revendications**

**1.** Dispositif optoélectronique comportant :

. une zone semi-conductrice active (84) pour la recombinaison radiative de paires électrons-trous réalisée sous la forme d'au moins un nanofil réalisé en un matériau semi-conducteur non intentionnellement dopé ;

. une zone semi-conductrice (88) pour l'injection radiale de trous dans le ou chaque nanofil, réalisée en un matériau semi-conducteur dopé d'un première type de conductivité et de bande interdite supérieure à la bande interdite du matériau constitutif du nanofil; et

. une zone semi-conductrice (82) pour l'injection axiale d'électrons dans le ou chaque nanofil, réalisée en un matériau semi-conducteur dopé d'un second type de conductivité opposé au premier type de conductivité.

**2.** Dispositif optoélectronique selon la revendication 1, dans lequel la zone active (84) est constituée d'un unique matériau semi-conducteur.

**3.** Dispositif optoélectronique selon la revendication 2, dans lequel la zone active (84) est constituée d'un matériau semi-conducteur de type III-V ou de type II-VI, et en particulier de type III-N.

**4.** Dispositif optoélectronique selon la revendication 3, dans lequel:

. la zone active (84) est constituée d'InGaN non intentionnellement dopé ;
. la zone dopée pour l'injection des trous (88) est constituée de GaN dopée p ou de InGaN dopé p de concentration en In inférieure à celle de la zone active ; et
. la zone dopée pour l'injection d' électrons (82) est constituée de Si dopé n ou de GaN dopé n.

**5.** Dispositif optoélectronique selon la revendication 3 ou 4, dans lequel la hauteur de la zone active (84) présente une valeur minimale sélectionnée selon la relation :

$$F.J_{overflow} = \left(\frac{4.N_C}{3.\sqrt{\pi}}\right)^2 \left(\frac{E_F - E_C}{k.T}\right)^3 .e.B.W_{DH}$$

où F est le facteur de remplissage des nanofils, Joverflow est la densité de courant maximale supportée par les nanofils sans saturation en électrons, Ne est la densité d'états effective de la bande conduction du matériau, e est la charge élémentaire, B est le coefficient de recombinaison bimoléculaire du matériau, et WDH est la valeur minimale de la hauteur de la zone active.

**6.** Dispositif optoélectronique selon la revendication 3, 4 ou 5, dans lequel la zone active est réalisé en InGaN, et :

- les nanofils (84) ont une densité comprise entre $10^8$ et $10^{10}$ par centimètre carré;
- les nanofils (84) ont un diamètre compris entre 50 nanomètres et 500 nanomètres ; et
- la hauteur de la zone active (84) est comprise entre 40 nanomètres et 5 micromètres.

**7.** Dispositif optoélectronique selon la revendication 6, dans lequel les nanofils (84) ont une densité de $4.10^9$ cm$^{-2}$, un diamètre de 100 nanomètres et une hauteur de zone active de 40 nanomètres.

**8.** Dispositif optoélectronique selon l'une quelconque des revendications précédentes, dans lequel il n'y a pas de zone bloqueuse d' électrons entre la zone active et la zone dopée p.

**9.** Dispositif optoélectronique selon l'une quelconque des revendications précédentes dans lequel les nanofils sont formés sur un substrat (82) en matériau semi-conducteur dopé n, le substrat formant la zone d'injection d'électrons.

**10.** Dispositif optoélectronique selon l'une quelconque des revendications 1 à 8, dans lequel les nanofils (84) comportent une base en semi-conducteur dopé n pour l'injection d'électrons.

**11.** Dispositif optoélectronique selon l'une quelconque des revendications 1 à 8, dans lequel les nanofils (84) sont formés sur substrat (82) qui comporte une couche continue de matériau semi-conducteur dopé n, de la même famille que le matériau constitutif de la zone active, et sur laquelle reposent les nanofils, ladite couche continue formant la zone pour l'injection d'électrons.

**12.** Dispositif optoélectronique selon l'une quelconque des revendications précédentes, *caractérisé* **en ce que** les nanofils (84) sont formés sur un substrat (82), et la zone pour l'injection de trous (88) enrobe partiellement la portion des nanofils (84) opposée au substrat (82).

13. Dispositif optoélectronique selon la revendication 12, dans lequel la zone pour l'injection de trous (88) enrobe moins des trois quarts de la périphérie des nanofils (84).

14. Dispositif optoélectronique selon l'une quelconque des revendications précédentes, dans lequel la zone pour l'injection de trous (88) forme une couche de matériau planarisante.

**Patentansprüche**

1. Optoelektronische Vorrichtung, Folgendes aufweisend:

   - eine aktive Halbleiterzone (84) zur Strahlungsrekombination von Elektronen-Loch-Paaren, die in Form mindestens eines Nanodrahts realisiert sind, der aus einem nicht absichtlich dotierten Material hergestellt ist;
   - eine Halbleiterzone (88) zur radialen Injektion von Löchern in den oder jeden Nanodraht, die aus einem Halbleitermaterial hergestellt ist, das mit einem ersten Leitfähigkeitstyp dotiert und von einem Bandabstand ist, der größer ist als der Bandabstand des den Nanodraht bildenden Materials; und
   - eine Halbleiterzone (82) zur axialen Injektion von Elektronen in den oder jeden Nanodraht, die aus einem Halbleitermaterial hergestellt ist, das mit einem dem ersten Leitfähigkeitstyp entgegengesetzten zweiten Leitfähigkeitstyp dotiert ist.

2. Optoelektronische Vorrichtung nach Anspruch 1, wobei die aktive Zone (82) aus einem einzigen Halbleitermaterial gebildet ist.

3. Optoelektronische Vorrichtung nach Anspruch 2, wobei die aktive Zone (84) aus einem Halbleitermaterial des Typs III-V oder des Typs II-VI und insbesondere des Typs III-N gebildet ist.

4. Optoelektronische Vorrichtung nach Anspruch 3, wobei:

   - die aktive Zone (84) aus nicht absichtlich dotiertem InGaN besteht;
   - die dotierte Zone (88) zur Injektion von Löchern aus p-dotiertem GaN oder p-dotiertem InGaN mit einer Konzentration an In besteht, die geringer ist als diejenige der aktiven Zone; und
   - die dotierte Zone (82) zur Injektion von Elektronen aus n-dotiertem Si oder n-dotierten GaN besteht.

5. Optoelektronische Vorrichtung nach Anspruch 3 oder 4, wobei die Höhe der aktiven Zone (84) einen Mindestwert aufweist, der nach dem Verhältnis:

$$F.J_{overflow} = \left(\frac{4.N_C}{3.\sqrt{\pi}}\right)^{2}\left(\frac{E_F - E_C}{k.T}\right)^{1}.e.B.W_{DH}$$

ausgewählt ist, worin F der Füllfaktor der Nanodrähte ist, Joverflow die maximale Stromdichte ist, die von den Nanodrähten ohne Sättigung an Elektronen ertragen wird, Ne die effektive Zustandsdichte des Leitungsbands des Materials ist, e die Elementarladung ist, B der bimolekulare Rekombinationskoeffizient des Materials ist, und WDH der Mindestwert der Höhe der aktiven Zone ist.

6. Optoelektronische Vorrichtung nach Anspruch 3, 4 oder 5, wobei die aktive Zone aus InGaN hergestellt ist, und

   ■ die Nanodrähte (84) eine Dichte zwischen $10^8$ und $10^{10}$ pro Quadratzentimeter haben;
   ■ die Nanodrähte (84) einen Durchmesser zwischen 50 Nanometer und 500 Nanometer haben; und
   ■ die Höhe der aktiven Zone (84) zwischen 40 Nanometer und 5 Mikrometer beträgt.

7. Optoelektronische Vorrichtung nach Anspruch 6, wobei die Nanodrähte (84) eine Dichte von $4,10^9$ cm$^{-2}$, einen Durchmesser von 100 Nanometer und eine Höhe der aktiven Zone von 40 Nanometer haben.

8. Optoelektronische Vorrichtung nach einem der vorhergehenden Ansprüche, wobei es keine Elektronensperrzone zwischen der aktiven Zone und der p-dotierten Zone gibt.

9. Optoelektronische Vorrichtung nach einem der vorhergehenden Ansprüche, wobei die Nanodrähte auf einem Substrat (82) aus n-dotiertem Halbleitermaterial ausgebildet sind, wobei das Substrat eine Elektroneninjektionszone bildet.

10. Optoelektronische Vorrichtung nach einem der Ansprüche 1 bis 8, wobei die Nanodrähte (84) eine Basis aus n-dotiertem Halbleiter zur Elektroneninjektion aufweisen.

11. Optoelektronische Vorrichtung nach einem der Ansprüche 1 bis 8, wobei die Nanodrähte (84) auf einem Substrat (82) ausgebildet sind, das eine durchgehende Schicht aus n-dotiertem Halbleitermaterial aus derselben Klasse wie das die aktive Zone bildenden Material aufweist, und auf der die Nanodrähte aufliegen, wobei die durchgehende Schicht die Zone zur Elektroneninjektion bildet.

12. Optoelektronische Vorrichtung nach einem der vorhergehenden Ansprüche, **dadurch gekennzeichnet, dass** die Nanodrähte (84) auf einem Substrat (82) ausgebildet sind, und die Zone (88) zur Injektion von Löchern den dem Substrat (82) entgegengesetzten Abschnitt der Nanodrähte (84) teilweise umhüllt.

13. Optoelektronische Vorrichtung nach Anspruch 12, wobei die Zone (88) zur Injektion von Löchern mindestens drei Viertel des Umfangs der Nanodrähte (84) umhüllt.

14. Optoelektronische Vorrichtung nach einem der vorhergehenden Ansprüche, wobei die Zone (88) zur Injektion von Löchern eine planarisierende Materialschicht bildet.

**Claims**

1. An optoelectronic device comprising:

   ▪ an active semiconductor area (84) for the radiative recombination of electron-hole pairs made in the form of at least one nanowire made of an unintentionally doped semiconductor material;
   ▪ a semiconductor area (88) for the radial injection of holes into the or each nanowire, made of a doped semiconductor material having a first conductivity type and a bandgap larger than the bandgap of the material forming the nanowire; and
   ▪ a semiconductor area (82) for the axial injection of electrons into the or each nanowire, made of a doped semiconductor material having a second conductivity type opposite to the first conductivity type.

2. The optoelectronic device of claim 1, wherein the active area (84) is made of a single semiconductor material.

3. The optoelectronic device of claim 2, wherein the active area (84) is formed of a semiconductor material of III-V type or of II-VI type, and in particular of III-N type.

4. The optoelectronic device of claim 3, wherein:

   ▪ the active area (84) is formed of unintentionally doped InGaN;
   ▪ the doped area for the injection of holes (88) is formed of p-doped GaN or of p-doped InGaN with a lower In concentration than the active area; and
   ▪ the doped area for the injection of electrons (82) is formed of n-doped Si or of n-doped GaN.

5. The optoelectronic device of claim 3 or 4, wherein the height of the active area (84) has a minimum value selected according to the following relation:

$$F.J_{overflow} = \left( \frac{4.N_C}{3.\sqrt{\pi}} \right)^2 . \left( \frac{E_F - E_C}{k.T} \right)^3 .e.B.W_{DH}$$

where F is the nanowire filling factor, $J_{overflow}$ is the maximum current density withstood by the nanowires with no electron saturation, $N_C$ is the effective density of states of the conduction band of the material, e is the elementary charge, B is the bimolecular recombination coefficient of the material, and $W_{DH}$ is the minimum value of the height of the active area.

6. The optoelectronic device of claim 3, 4, or 5, wherein the active area is made of InGaN, and:

   - the nanowires (84) have a density ranging between $10^8$ and $10^{10}$ per square centimeter;
   - the nanowires (84) have a diameter ranging between 50 nanometers and 500 nanometers; and
   - the height of the active area (84) of the nanowires ranges between 40 nanometers and 5 micrometers.

7. The optoelectronic device of claim 6, wherein the nanowires (84) have a density of $4.10^9$ cm$^{-2}$, a diameter of 100 nanometers, and an active area height of 40 nanometers.

8. The opotoelectronic device of any of the foregoing claims, wherein there is no electronic blocking area between the active area and the p-doped area.

9. The opotoelectronic device of any of the foregoing claims, wherein the nanowires are formed on a substrate (82) made of n-doped semiconductor material, the substrate forming the electron injection area.

10. The opotoelectronic device of any of claims 1 to 8, wherein the nanowires (84) comprise a base of n-doped semiconductor for the injection of electrons.

11. The optoelectronic device of any of claims 1 to 8, wherein the nanowires (84) are formed of a substrate (82) which comprises a continuous layer of n-doped semiconductor material, of the same family as the material forming the active area, and supporting the nanowires, said continuous layer forming the electron injection area.

12. The opotoelectronic device of any of the foregoing claims, wherein the nanowires (84) are formed on a substrate (82), and the hole injection area (88) partially coats the portion of the nanowires (84) opposite to the substrate (82).

13. The opotoelectronic device of claim 12, wherein the hole injection area (88) coats less than three quarters of the periphery of the nanowires (84).

14. The opotoelectronic device of any of the foregoing claims, wherein the hole injection area (88) forms a planarizing material layer.

**Fig. 1**
(Etat de la technique)

**Fig. 2**
(Etat de la technique)

**Fig. 3**
(Etat de la technique)

**Fig. 4**
(Etat de la technique)

**Fig. 5**

**Fig. 6**

Fig. 7

Fig. 8

Fig. 9

Fig. 10

Fig. 11

Fig. 12

Fig. 13

Fig. 14

Fig. 15

Fig. 16

Fig. 17

**Fig. 18**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008079077 A2
- WO 2009106636 A

- WO 2009087319 A

**Littérature non-brevet citée dans la description**

- **N.F. GARDNER et al.** Blue-emitting InGaN-GaN double-heterostructure light-emitting diodes reaching maximum quantum efficiency above 200 A/cm. *Applied Physics Letters,* 2007, vol. 91, 243506